# EUROPÄISCHE PATENTANMELDUNG

(11) **EP 1 098 440 A2**
(43) Veröffentlichungstag der Anmeldung: **09.05.2001**
(21) Anmeldenummer: 00123201.6
(22) Anmeldetag: 26.10.2000
(51) Int. Cl.: H03L 7/23

(54) **Zeitbasisgenerator**

(30) Priorität: 03.11.1999 DE 19952826
(71) Anmelder: Krohne S.A., 26103 Romans - Cedex (FR)
(72) Erfinder: Thollet, Alexandre, 69610 Sainte Foy l'Argentière (FR); Bletz, Achim, Dipl.-Ing., 07300 Tournon sur Rhone (FR)
(74) Vertreter: Gesthuysen, von Rohr & Eggert

(57) **Zusammenfassung**

Dargestellt und beschrieben ist eine Anordnung zum Erzeugen eines ersten zeitlich alternierenden Signals und eines zweiten zeitlich alternierenden Signals, das zum ersten Signal in einem vorbestimmten festen Frequenzverhältnis steht, mit einem ersten Oszillator (1), einem zweiten Oszillator (2) und einem dritten Oszillator (3), wobei der erste Oszillator (1) ein seiner Schwingungsfrequenz entsprechendes Schwingungssignal an einen ersten digitalen Frequenzteiler (4 ) liefert, der daraus das erste Signal erzeugt und ein seiner Schwingungsfrequenz entsprechendes Schwingungssignal an einen zweiten digitalen Frequenzteiler (5 ) liefert, der daraus ein erstes Synchronisationssignal erzeugt, wobei der zweite Oszillator (2) ein seiner Schwingungsfrequenz entsprechendes Schwingungssignal an einen dritten digitalen Frequenzteiler (6) liefert, der daraus ein zweites Synchronisationssignal erzeugt und ein seiner Schwingungsfrequenz entsprechendes Schwingungssignal an einen vierten digitalen Frequenzteiler (7) liefert, der daraus ein drittes Synchronisationssignal erzeugt, wobei der dritte Oszillator (3) ein seiner Schwingungsfrequenz entsprechendes Schwingungssignal an eine fünften digitalen Frequenzteiler (8) liefert, der daraus ein viertes Synchronisationssignal erzeugt und ein seiner Schwingungsfrequenz entsprechendes Schwingungssignal an einen sechsten digitalen Frequenzteiler (9) liefert, der daraus das zweite Signal erzeugt, wobei das erste Synchronisationssignal und das zweite Synchronisationssignal einem ersten Phasenvergleicher (10) zugeführt werden, der in Abhängigkeit von der Phasendifferenz des ersten Synchronisationssignals zum zweiten Synchronisationssignal eine Spannung an einen ersten spannungsgesteuerten Oszillator (11) ausgibt, der die Schwingungsfrequenz des zweiten Oszillators (2) derart regelt, daß diese zur Schwingungsfrequenz des ersten Oszillators (1) in einem vorbestimmten festen Verhältnis steht, und wobei das dritte Synchronisationssignal und das vierte Synchronisationssignal einem zweiten Phasenvergleicher (12) zugeführt werden, der in Abhängigkeit von der Phasendifferenz des dritten Synchronisationssignals zum vierten Synchronisationssignal eine Spannung an einen zweiten spannungsgesteuerten Oszillator (13) ausgibt, der die Schwingungsfrequenz des dritten Oszillators (3) derart regelt, daß diese zur Schwingungsfrequenz des zweiten Oszillators (2) in einem vorbestimmten festen Verhältnis steht.

## Beschreibung

Die Erfindung betrifft eine Anordnung zum Erzeugen eines ersten zeitlich alternierenden Signals und eines zweiten zeitlich alternierenden Signals, das zum ersten Signal in einem vorbestimmten festen Frequenzverhältnis steht. Eine solche Anordnung dient z. B. als Zeitbasisgenerator für ein Füllstandsmeßgerät, das nach dem Radarprinzip arbeitet und dessen Meßsystem auf dem TDR-Meßprinzip (Time Domain Reflectometry) basiert. Das TDR-Meßprinzip ist z. B. aus dem Bereich der Kabelprüfung bekannt und weist Ähnlichkeiten mit der Funktionsweise von Radargeräten auf. Bei einem TDR-Füllstandsmeßgerät wird ein extrem kurzer elektrischer Impuls, geführt über zwei im wesentlichen gerade verlaufende elektrische Leiter, in einen Behälter ausgesandt, in dem sich ein Medium, wie eine Flüssigkeit, ein Pulver oder ein Granulat, befindet, dessen Füllstand bestimmt werden soll. Der über die beiden Leiter in den Behälter ausgesandte kurze elektrische Impuls wird an der Oberfläche des Mediums reflektiert, und der reflektierte Anteil des kurzen elektrischen Impulses wird von einem Meßumformer des Meßgeräts wieder detektiert. Der reflektierte Anteil des kurzen elektrischen Impulses hängt von der Dielektrizitätszahl des Mediums ab und steigt mit dieser. Die Laufzeit des Signals ist dabei proportional zum Abstand des Meßumformers zur Oberfläche des in dem Behälter befindlichen Mediums. Sich verändernde Umgebungsbedingungen, wie ein steigender oder fallender Umgebungsdruck oder eine steigende oder fallende Temperatur, beeinträchtigen die Meßgenauigkeit des TDR-Füllstandsmeßgeräts nicht. Außerdem ist die Laufzeit des Signals unabhängig von der Dielektrizitätszahl des Mediums, dessen Füllstand gemessen werden soll.

Das TDR-Meßprinzip beruht somit darauf, daß die - unter Umständen sehr kurzen - Laufzeiten eines elektromagnetischen Signals gemessen werden. Ist der Behälter annähernd vollständig mit dem Medium gefüllt, so daß die Oberfläche des Mediums beispielsweise lediglich 15 cm unterhalb des Meßumformers des TDR-Füllstandsmeßgeräts liegt, beträgt die Gesamtlaufstrecke des elektromagnetischen Signals vom Meßumformer zur Oberfläche des Mediums und wieder zurück lediglich 30 cm, was einer Laufzeit des kurzen elektrischen Impulses von 1 ns entspricht. Um solch kurze Laufzeiten überhaupt messen zu können, bedient man sich eines Sampling-Verfahrens, für welches zwei schnelle, zeitlich alternierende Signale erzeugt werden, die zueinander eine gewisse Frequenzdifferenz im Bereich von wenigen Hertz aufweisen. Eine Messung wird dann derart durchgeführt, daß zu einem Zeitpunkt Null, zu dem die beiden schnellen, zeitlich alternierenden Signale gleichphasig schwingen, mit der Messung begonnen wird. Dabei gibt das höherfrequenter schwingende Signal den Takt für die Aussendung des eigentlichen Meßsignals, d. h. des kurzen elektrischen Impulses, in den Behälter an. So wird z. B. immer zu Beginn einer Periode des höherfrequenter schwingenden Signals ein kurzer elektrischer Impuls generiert und in den Behälter ausgesandt. Das niedrigerfrequenter schwingende Signal eilt dem höherfrequenter schwingenden Signal pro Schwingungsperiode um einen gewissen geringen Betrag nach, bei einer Frequenzdifferenz von z. B. 4 Hz und einer Schwingungsfrequenz der beiden Signale von etwa 1 MHz nämlich etwa 4 ps pro Periode. Diese Zeitdauer von 4 ps gibt somit das digitale Zeitraster bzw. die digitale Zeitbasis an, mit welcher die Laufzeit des in dem Behälter ausgesandten und an der Oberfläche des Mediums reflektierten kurzen elektrischen Impulses gemessen wird.

Während das höherfrequenter schwingende Signal den Takt für die Aussendung des kurzen elektrischen Impulses in den Behälter angibt, bestimmt das niedrigerfrequenter schwingende Signal, zu welchem Zeitpunkt für eine extrem kurze Zeitdauer ein reflektiertes Signal detektiert werden kann. Gemäß dem oben beschriebenen Beispiel würde also gemessen vom Zeitpunkt der Gleichphasigkeit der beiden zeitlich alternierenden Signale an nach 1000 Schwingungsperioden ein reflektierter Impuls detektiert, der eine Laufzeit von 4 ns gehabt hätte, was einer gesamten Laufstrecke von 1,2 m und somit einem Füllstand des zu messenden Mediums von 60 cm unter dem Meßumformer des TDR-Füllstandsmeßgeräts entspricht.

Zur Erzeugung einer Zeitbasis für ein TDR-Füllstandsmeßgerät sind bisher Zeitbasisgeneratoren verwendet worden, die im wesentlichen folgenden Aufbau haben:

Mit zwei Oszillatoren, die jeweils mit einer Schwingungsfrequenz von einigen 10 MHz betrieben werden, werden ein erstes Schwingungssignal und ein zweites Schwingungssignal erzeugt. Diese beiden Schwingungssignale werden einerseits mit Hilfe von digitalen Frequenzteilern mit einer entsprechenden Frequenzteilung derart heruntergeteilt, daß z. B. ein Signal von 1 MHz und ein zweites Signal von 1,000004 MHz erhalten wird, das erste Signal und das zweite Signal also eine Frequenzdifferenz von 4 Hz aufweisen. Die Schwingungssignale der beiden Oszillatoren werden andererseits jeweils einem dritten bzw. einem vierten digitalen Frequenzteiler zugeführt, die die beiden Schwingungsfrequenzen der verschiedenen Oszillatoren derart digital herunterteilen, daß dadurch aus den beiden voneinander verschiedenen Schwingungsfrequenzen eine gemeinsame gleiche Synchronisationsfrequenz erhalten wird. Die von dem dritten digitalen Frequenzteiler erzeugte Synchronisationsfrequenz sowie die von dem vierten digitalen Frequenzteiler erzeugte Synchronisationsfrequenz werden einem Phasenvergleicher zugeführt, der in Abhängigkeit von der Phasendifferenz zwischen den beiden empfangenen Signalen eine Spannung an einen spannungsgesteuerten Oszillator ausgibt, der seinerseits die Frequenz des zweiten Oszillators derart regelt, daß die Frequenzen der beiden Oszillatoren zueinander in einem vorbestimmten festen Frequenzverhältnis stehen, so daß die beiden von dem Zeitbasisgenerator erzeugten und ausgegebenen Signale eine vorbestimmte, feste Frequenzdifferenz, vorliegend 4 Hz, aufweisen. Auf diese Weise wird erreicht, daß unabhängig von Frequenzänderungen des ersten Oszillators, z. B. aufgrund von Temperatureinflüssen, immer die fest voreingestellte Frequenzdifferenz zwischen den beiden Signalen eingehalten wird. Dabei sei angemerkt, daß aufgrund des Verhältnisses der beiden von dem Zeitbasisgenerator erzeugten und ausgegebenen Signale, das sehr nahe bei 1 liegt, die Aufrechterhaltung des fest voreingestellten Frequenzverhältnisses zwischen den beiden Signalen im praktischen Betrieb, in dem aufgrund äußerer Einflüsse nur geringe Schwankungen der Frequenz des ersten Oszillators auftreten, auch der Anforderung entspricht, daß die Frequenzdifferenz zwischen den beiden Signalen konstant bleibt.

Das Prinzip eines solchen Zeitbasisgenerators basiert somit darauf, daß der erste Oszillator mit einer ersten Frequenz angeregt wird, jedoch aufgrund von Umgebungseinflüssen, wie Temperaturänderungen, wenigstens geringe Abweichungen von seinem voreingestellten Wert erfahren kann. Da für die Genauigkeit der Zeitmessung jedoch wesentlich ist, daß zu der Frequenz des ersten Oszillators eine exakt vorbestimmte und immer gleichbleibende Frequenzdifferenz besteht, die ja das Zeitraster für die Zeitbasis darstellt, muß auch die Frequenz des zweiten Oszillators entsprechend nachgeführt werden, wenn sich die Frequenz des ersten Oszillators verändert. Dazu dient der oben beschriebene Aufbau, in dem ein PLL (Phase Locked Loop) verwendet wird, um die Frequenz des zweiten Oszillators auf den jeweils richtigen Wert einzuregeln. Ein PLL besteht im allgemeinen im wesentlichen aus einem Phasenvergleicher und einem spannungsgesteuerten Oszillator. Der Phasenvergleicher erhält dabei einerseits ein Referenzsignal, an dessen Frequenz das Signal in dem PLL angepaßt werden soll, sowie andererseits ein Signal von dem spannungsgesteuerten Oszillator, das dem Phasenvergleicher entweder direkt oder weiterverarbeitet zugeführt werden kann. Der Phasenvergleicher gibt dann ein Spannungssignal in Abhängigkeit von der Phasendifferenz der beiden ihm zugefügten Signale an den spannungegesteuerten Oszillator aus, das somit zur Steuerung von dessen Ausgabefrequenz dient. Mit solch einem Regelkreis eines PLL ist es dann möglich, eine im PLL erzeugte Frequenz einer äußeren Referenzfrequenz nachzuführen. Vorliegend sind Bestandteile des PLL der Phasenvergleicher, der spannungsgesteuerte Oszillator, der zweite Oszillator sowie der dritte digitale Frequenzteiler, und die Frequenz des zweiten Oszillators wird in einem vorbestimmten festen Verhältnis der Frequenz des ersten Oszillators nachgeführt, die somit die Referenzfrequenz darstellt.

Die meisten herkömmlichen TDR-Füllstandsmeßgeräte weisen einen solchen Zeitbasisgenerator mit einem PLL auf. Typische Schwingungsfrequenzen der beiden Oszillatoren liegen dabei zwischen 20 und 40 MHz. Bei einer Schwingungsfrequenz in dieser Größenordnung ist die Leistungsaufnahme der Schwingquarze jedoch zu groß, um das gesamte TDR-Füllstandsmeßgerät über eine Zweileiter-Schnittstelle und somit über eine Zweidrahtschaltung versorgen zu können. Die Begriffe "Zweileiter-Schnittstelle" bzw. "Zweidrahtleitung" betreffen dabei ein Anordnung, bei der über eine einzige zweiadrige Leitung sowohl das Meßsignal geführt wird als auch das Meßgerät mit elektrischer Leistung versorgt wird. Das Meßsignal liegt dabei typischerweise zwischen 4 und 20 mA, und für die Versorgung des Meßgeräts stehen typischerweise maximal 40 mW zur Verfügung.

Für den Betrieb des TDR-Füllstandsmeßgerät würde sich eine Verringerung der Leistungsaufnahme der Oszillatoren - meistens gebildet aus Schwingquarzen - grundsätzlich dadurch erreichen lassen, daß die Schwingungsfrequenzen der Schwingquarze reduziert werden, da deren Leistungsaufnahme etwa linear mit deren Schwingungsfrequenz ansteigt. Eine Zeitbasisgeneratorschaltung, bei der die Leistungsaufnahme so gering ist, daß für das gesamte TDR-Füllstandsmeßgerät zur Versorgung und zur Meßwertübermittlung lediglich eine Zweileiter-Schnittstelle bzw. eine Zweidrahtleitung ausreicht, muß zwei Bedingungen erfüllen: Einerseits müssen die Frequenzen der Oszillatoren deutlich unter 10 MHz liegen, damit die Leistungsaufnahme nicht zu groß ist, andererseits dürfen die Synchronisationsfrequenzen, die dem Phasenvergleicher zugeführt werden und den Takt für das Nachregeln der Frequenz des zweiten Oszillators angeben, nicht geringer als 1 kHz sein, da ansonsten das System zu träge ist und keine stabile Zeitbasis generiert werden kann. Eine solche Zeitbasis mit ausreichend geringen Schwingungsfrequenzen der Oszillatoren einerseits und einer ausreichend großen Synchronisationsfrequenz andererseits läßt sich jedoch mit der herkömlichen PLL-Schaltung nicht realisieren.

Es ist somit die Aufgabe der Erfindung, eine Anordnung sowie ein Verfahren zum Erzeugen zweier zeitlich alternierender Signale bereitzustellen, die zueinander in einem vorbestimmten, festen Frequenzverhältnis stehen, wobei bei einer Abweichung einer Frequenz von ihrem Sollwert die andere Frequenz schnell nachgeregelt wird und die Leistungsaufnahme gering ist.

Die zuvor hergeleitete und aufgezeigte Aufgabe wird erfindungsgemäß gelöst durch eine Anordnung zum Erzeugen eines ersten zeitlich alternierenden Signals und eines zweiten zeitlich alternierenden Signals, das zum ersten Signal in einem vorbestimmten festen Frequenzverhältnis steht, mit einem ersten Oszillator, einem zweiten Oszillator und einem dritten Oszillator, wobei der erste Oszillator ein seiner Schwingungsfrequenz entsprechendes Schwingungssignal an einen ersten digitalen Frequenzteiler liefert, der daraus das erste Signal erzeugt, und ein seiner Schwingungsfrequenz entsprechendes Schwingungssignal an einen zweiten digitalen Frequenzteiler liefert, der daraus ein erstes Synchronisationssignal erzeugt, wobei der zweite Oszillator ein seiner Schwingungsfrequenz entsprechendes Schwingungssignal an einen dritten digitalen Frequenzteiler liefert, der daraus ein zweites Synchronisationssignal erzeugt und ein seiner Schwingungsfrequenz entsprechendes Schwingungssignal an einen vierten digitalen Frequenzteiler liefert, der daraus ein drittes Synchronisationssignal erzeugt, wobei der dritte Oszillator ein seiner Schwingungsfrequenz entsprechendes Schwingungssignal an einen fünften digitalen Frequenzteiler liefert, der daraus ein viertes Synchronisationssignal erzeugt und ein seiner Schwingungsfrequenz entsprechendes Schwingungssignal an einen sechsten digitalen Frequenzteiler liefert, der daraus das zweite Signal erzeugt, wobei das erste Synchronisationssignal und das zweite Synchronisationssignal einem ersten Phasenvergleicher zugeführt werden, der in Abhängigkeit von der Phasendifferenz des ersten Synchronisationssignals zum zweiten Synchronisationssignal eine Spannung an einen ersten spannungsgesteuerten Oszillator ausgibt, der die Schwingungsfrequenz des zweiten Oszillators derart regelt, daß diese zur Schwingungsfrequenz des ersten Oszillators in einem vorbestimmten festen Verhältnis steht, und wobei das dritte Synchronisationssignal und das vierte Synchronisationssignal einem zweiten Phasenvergleicher zugeführt werden, der in Abhängigkeit von der Phasendifferenz des dritten Synchronisationssignals zum vierten Synchronisationssignal eine Spannung an einen zweiten spannungsgesteuerten Oszillator ausgibt, der die Schwingungsfrequenz des dritten Oszillator derart regelt, daß diese zur Schwingungsfrequenz des zweiten Oszillators in einem vorbestimmten festen Verhältnis steht.

Andererseits wird die weiter oben aufgezeigte und hergeleitete Aufgabe erfindungsgemäß gelöst durch ein Verfahren zum Erzeugen eines ersten zeitlich alternierenden Signals und eines zweiten zeitlich alternierenden Signals, das zum ersten Signal in einem vorbestimmten festen Frequenzverhältnis steht, wobei ein erstes Schwingungssignal mit einer ersten Schwingungsfrequenz, ein zweites Schwingungssignal mit einer zweiten Schwingungsfrequenz und ein drittes Schwingungssignal mit einer dritten Schwingungsfrequenz erzeugt werden, wobei das erste Signal aus dem ersten Schwingungssignal erzeugt wird, indem die Schwingungsfrequenz des erste Schwingungssignals um eine erste Frequenzteilung ganzzahlig heruntergeteilt wird, ein erstes Synchronisationssignal aus dem ersten Schwingungssignal erzeugt wird, indem die Schwingungsfrequenz des ersten Schwingungssignals um eine zweite Frequenzteilung ganzzahlig heruntergeteilt wird, ein zweites Synchronisationssignal aus dem zweiten Schwingungssignal erzeugt wird, indem die Schwingungsfrequenz des zweiten Schwingungssignals um eine dritte Frequenzteilung ganzzahlig heruntergeteilt wird, ein drittes Synchronisationssignal aus dem zweiten Schwingungssignal erzeugt wird, indem die Schwingungsfrequenz des zweiten Schwingungssignals um eine vierte Frequenzteilung ganzzahlig heruntergeteilt wird, ein viertes Synchronisationssignal aus dem dritten Schwingungssignal erzeugt wird, indem die Schwingungsfrequenz des dritten Schwingungssignals um eine fünfte Frequenzteilung ganzzahlig heruntergeteilt wird, und das zweite Signal aus dem dritten Schwingungssignal erzeugt wird, indem die Schwingungsfrequenz des dritten Schwingungssignals um eine sechste Frequenzteilung ganzzahlig heruntergeteilt wird, wobei die Phase des ersten Synchronisationssignals mit der Phase des zweiten Synchronisationssignals verglichen wird und die zweite Schwingungsfrequenz in Abhängigkeit von der Phasendifferenz des ersten Synchronisationssignals zum zweiten Synchronisationssignal derart geregelt wird, daß diese zur ersten Schwingungsfrequenz in einem vorbestimmten festen Verhältnis steht, und wobei die Phase des dritten Synchronisationssignals mit der Phase des vierten Synchronisationssignals verglichen wird und die dritte Schwingungsfrequenz in Abhängigkeit von der Phasendifferenz des dritten Synchronisationssignals zum vierten Synchronisationssignal derart geregelt wird, daß diese zur zweiten Schwingungsfrequenz in einem vorbestimmten festen Verhältnis steht.

Erfindungsgemäß ist somit vorgesehen, daß dem ersten PLL, wie er auch im Stand der Technik verwendet wird, ein zweiter PLL nachgeschaltet ist, so daß mit der erhöhten Anzahl von digitalen Frequenzteilern auch bei geringen Schwingungsfrequenzen der Oszialltoren von unter 10 MHz ein ausreichend feines zeitliches Raster von wenigen Picosekunden erzielbar ist und die Frequenz des zweiten Signals trotzdem mit einer entsprechend hohen Frequenz von über 1 kHz der ersten Frequenz mit dem vorbestimmten festen Frequenzverhältnis nachgeführt werden kann.

Die erfindungsgemäße Anordnung sowie das erfindungsgemäße Verfahren sind bevorzugt dadurch weitergebildet, daß die Frequenz des ersten zeitlich alternierenden Signals und die Frequenz des zweiten zeitlich alternierenden Signals beide jeweils zwischen 0,1 und 10 MHz liegen, vorzugsweise etwa 1 MHz betragen.

Ferner sind die erfindungsgemäße Anordnung sowie das erfindungsgemäße Verfahren bevorzugt dadurch weitergebildet, daß das vorbestimmte feste Frequenzverhältnis zwischen dem ersten zeitlich alternierenden Signal und dem zweiten zeitlich alternierenden Signal derart gewählt ist, daß der Differenzbetrag zwischen der Frequenz des ersten zeitlich alternierenden Signals und der Frequenz des zweiten zeitlich alternierenden Signals zwischen 1 und 10 Hz liegt, vorzugsweise etwa 4 Hz beträgt. Bei zeitlich alternierenden Signalen mit einer Frequenz von etwa 1 MHz wird mit einer Differenzfrequenz von 4 Hz somit ein Zeitraster von 4 ps erzielt.

Vorzugsweise werden bei der erfindungsgemäßen Anordnung der erste Oszillator, der zweite Oszillator und der dritte Oszillator jeweils von einem Schwingquarz gebildet und dementsprechend bei dem erfindungsgemäßen Verfahren das erste Schwingungssignal, das zweite Schwingungssignal und das dritte Schwingungssignal jeweils von einem Schwingquarz erzeugt.

Wie oben schon ausgeführt, sind die erfindungsgemäße Anordnung sowie das erfindungsgemäße Verfahren insbesondere als Zeitbasisgenerator bzw. als Zeitbasisgeneratorverfahren für ein TDR-Füllstandsmeßgerät geeignet. Selbstverständlich lassen sich jedoch die erfindungsgemäße Anordnung sowie das erfindungsgemäße Verfahren auch auf andere Geräte und Anwendungen übertragen, bei denen eine entsprechende digitale Zeitbasis erforderlich ist.

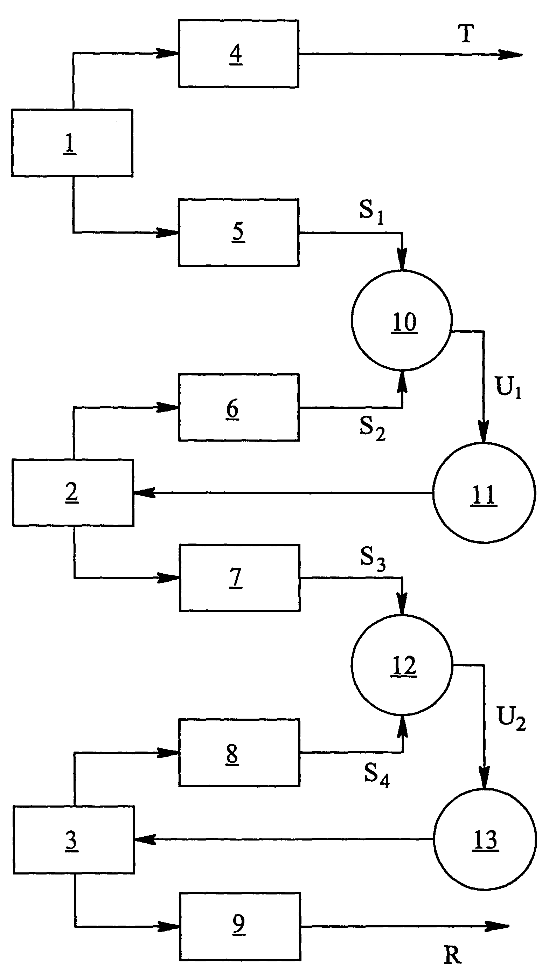

Im einzelnen gibt es nun eine Vielzahl von Möglichkeiten, die erfindungsgemäße Anordnung sowie das erfindungsgemäße Verfahren zu realisieren. Dazu wird einerseits auf die dem Patentanspruch 1 bzw. dem Patentanspruch 9 nachgeordneten Patentansprüche, andererseits auf die nachfolgende Beschreibung eines bevorzugten Ausführungsbeispiels der Erfindung in Verbindung mit der Zeichnung verwiesen

In der Zeichnung zeigt die einzigen Figur schematisch die Schaltung der erfindungsgemäßen Anordnung.

Wie aus der Figur ersichtlich, sind gemäß dem bevorzugten Ausführungsbeispiel der Erfindung ein erster Oszillator 1, ein zweiter Oszillator 2 und ein dritter Oszillator 3 vorgesehen. Dabei schwingt der erste Oszillator 1 mit einer Schwingungsfrequenz von 5 MHz, der zweite Oszillator 2 schwingt mit einer Schwingungsfrequenz von 3,579545 MHz und der dritte Oszillator 3 schwingt mit einer Schwingungsfrequenz von etwa 4 MHz. Die Anordnung gemäß dem ersten bevorzugten Ausführungsbeispiel der Erfindung soll ein erstes zeitlich alternierendes Signal T mit einer Frequenz von 1 MHz und ein zweites zeitlich alternierendes Signal R mit einer Frequenz von etwa 1,000004 MHz liefern. Dazu ist vorgesehen, daß der erste Oszillator 1 ein seiner Schwingungsfrequenz von 5 MHz entsprechendes Schwingungssignal an einen ersten digitalen Frequenzteiler 4 liefert, der daraus durch eine digitale Frequenzteilung um 5 das erste Signal mit einer Frequenz von 1 MHz erzeugt. Andererseits liefert der erste Oszillator 1 ein seiner Schwingungsfrequenz von 5 MHz entsprechendes Schwingungssignal an einen zweiten digitalen Frequenzteiler 5, der daraus durch eine digitale Frequenzteilung um 264 ein erstes Synchronisationssignal S₁ erzeugt.

Der zweite Oszillator 2 liefert ein seiner Schwingungsfrequenz von 3,579545 MHz entsprechendes Schwingungssignal an einen dritten digitalen Frequenzteiler 6, der daraus durch eine digitale Frequenzteilung um 189 ein zweites Synchronisationssignal S₂ erzeugt. Außerdem liefert der zweite Osziallator 2 ein seiner Schwingungsfrequenz von 3,579545 MHz entsprechendes Schwingungssignal an einen vierten digitalen Frequenzteiler 7, der daraus durch eine digitale Frequenzteilung um 647 ein drittes Synchronisationssignal S₃ erzeugt. Der dritte Oszillator 3 liefert ein seiner Schwingungsfrequenz von etwa 4 MHz entsprechendes Schwingungssignal an einen fünften digitalen Frequenzteiler 8, der daraus durch eine digitale Frequenzteilung um 723 ein viertes Synchronisationssignal S₄ erzeugt. Schließlich liefert der dritte Oszillator 3 ein seiner Schwingungsfrequenz von etwa 4 MHz entsprechendes Schwingungssignal an einer sechsten digitalen Frequenzteiler 9, der daraus durch eine digitale Frequenzteilung um 4 das zweite Signal R mit einer Frequenz von etwa 1,000004 MHz erzeugt.

Die Nachregelung des zweiten zeitlich alternierenden Signals R entsprechend einer Änderung des ersten zeitlich alternierenden Signals T, also das Einhalten eines vorbestimmten, festen Frequenzverhältnisses zwischen dem ersten Signal T und dem zweiten Signal R, was in der Praxis bei nur geringen Abweichungen der Schwingungsfrequenz des Oszillators 1 von 5 MHz auch einem festen, vorbestimmten Differenzbetrag zwischen der Frequenz des ersten zeitlich alternierenden Signals T und der Frequenz des zweiten zeitlich alternierenden Signals R entspricht, erfolgt erfindungsgemäß durch zwei einander nachgeschaltete PLLs. Dazu sind gemäß dem ersten bevorzugten Ausführungsbeispiel der Erfindung in einem ersten PLL ein Phasenvergleicher 10, der das erste Synchronisationssignal S₁ und das zweite Synchronisationssignal S₂ empfängt, sowie ein spannungsgesteuerter Oszillator 11 vorgesehen, der von dem Phasenvergleicher 10 mittels einer Spannung U₁ angesteuert wird und dadurch seinerseits die Schwingungsfrequenz des zweiten Oszillators 2 regelt. In einem zweiten PLL sind ein Phasenvergleicher 12, der das dritte Synchronisationssignal S₃ und das vierte Synchronisationssignal S₄ empfängt, sowie ein spannungsgesteuerter Oszillator 13 vorgesehen, der von dem Phasenvergleicher 12 mittels einer Spannung U₂ angesteuert wird und seinerseits die Schwingungsfrequenz des dritten Oszillators 3 regelt.

In dem ersten PLL erfolgt die Regelung der Schwingungsfrequenz des zweiten Oszillators 2 durch den spannungsgesteuerten Oszillator 11 derart, daß der Phasenvergleicher 10 in Abhängigkeit von der Phasendifferenz zwischen dem ersten Synchronisationssignal S₁ und dem zweiten Synchronisationssignal S₂ eine Spannung U₁ an den spannungsgesteuerten Oszillator 11 liefert, so daß dieser den Oszillator 2 derart regelt, daß dessen Schwingungsfrequenz in einem festen, vorbestimmten Verhältnis zur Schwingungsfrequenz des ersten Oszillators 1 steht, das gemäß dem hier erläuterten bevorzugten Ausführungsbeispiel der Erfindung 3,579545 zu 5 beträgt. Dieses Frequenzverhältnis wurde insofern gewählt, da sich entsprechende Frequenzteilungen durch den zweiten digitalen Frequenzteiler 5 bzw. den dritten digitalen Frequenzteiler 6 durch digitale Frequenzteilungen von 264 bzw. 189 günstig realisieren lassen, ohne daß dabei die Synchronisationsfrequenz des ersten PLL zu gering ist. Gemäß dem ersten bevorzugten Ausführungsbeispiel der Erfindung wird nämlich eine erste Synchronisationsfrequenz S₁ bzw. eine dieser entsprechende zweite Synchronisationsfrequenz S₂ von etwa 18,9 kHz erzielt. Dieser Wert liegt deutlich über dem in der Praxis gefundenen Wert von 1 kHz, bei dem sich gerade noch eine ausreichend stabile Zeitbasis generieren läßt.

Die Funktionsweise des zweiten PLL entspricht im wesentlichen dem des ersten PLL. Während das dem Phasenvergleicher 12 zugeführte Synchronisationssignal S₃ aufgrund der Regelung im ersten PLL schon ein einer Veränderung des ersten Signals T nachgeführtes Signal darstellt, wird dem Phasenvergleicher 12 durch das Synchronisationssignal S₄ eine Information über die Schwingungsabweichungen des dritten Oszillators 3 von dem vorbestimmten festen Frequenzverhältnis des ersten Signals zum zweiten Signal zugeführt. Die Regelung der Schwingungsfrequenz des dritten Oszillators 3 erfolgt dann entsprechend der Regelung im ersten PLL über die von dem Phasenvergleicher 12 an den spannungsgesteuerten Oszillator 13 abgegebene Spannung U₂ und ein entsprechendes Regeln der Frequenz des dritten Oszillators 3 durch den spannungsgesteuerten Oszillator 13. Entsprechend der Schwingungsfrequenz des zweiten Oszillators 2 von 3,579545 MHz bzw. der Schwingungsfrequenz des dritten Oszillators 3 von etwa 4 MHz sind die Frequenzteilung des vierten digitalen Frequenzteiles 7 zu 647 und die Frequenzteilung des fünften digitalen Frequenzteilers 8 zu 723 gewählt worden. Um ein zweites Signal von etwa 1,000004 MHz zu erzielen, beträgt die Frequenzteilung des sechsten digitalen Frequenzteilers 9 4. Auf diese Weise wird auch in dem zweiten PLL eine ausreichend große dritte Synchronisationsfrequenz S₃ bzw. eine dieser entsprechende vierte Synchronisationsfrequenz S₄ von etwa 5,5 kHz erzielt.

Im Ergebnis bleibt festzuhalten, daß eine Anordnung gemäß dem in der Figur gezeigten bevorzugten Ausführungsbeispiel der Erfindung im Gegensatz zu herkömmlichen Anordnungen eine wesentlich verringerte Leistungsaufnahme aufweist, obwohl ein zusätzlicher Oszillator vorgesehen ist. Konkret hat gemäß dem Stand der Technik bisher eine Anordnung mit zwei Oszillatoren Verwendung gefunden, die mit einer jeweiligen Schwingungsfrequenz von 32 MHz bzw. 21 MHz betrieben worden sind. Gegenüber einer solchen Anordnung weist die Anordnung gemäß dem bevorzugten Ausführungsbeispiel der Erfindung eine um wenigstens den Faktor 4 verminderte Leistungsaufnahme auf, so daß eine Übertragung der Meßwerte sowie die Versorgung eines gesamten, eine solche Anordnung als Zeitbasisgenerator aufweisenden TDR-Füllstandsmeßgeräts über ausschließlich eine Zweileiter-Schnittstelle bzw. Zweidrahtleitung erfolgen kann. Im Hinblick auf den Explosionsschutz ermöglicht dies eine eigensichere Ausführung eines solchen TDR-Füllstandsmeßgeräts und seiner Zuleitungen.

## Patentansprüche

1. Anordnung zum Erzeugen eines ersten zeitlich alternierenden Signals und eines zweiten zeitlich alternierenden Signals, das zum ersten Signal in einem vorbestimmten festen Frequenzverhältnis steht, mit einem ersten Oszillator (1), einem zweiten Oszillator (2) und einem dritten Oszillator (3), wobei der erste Oszillator (1) ein seiner Schwingungsfrequenz entsprechendes Schwingungssignal an einen ersten digitalen Frequenzteiler (4) liefert, der daraus das erste Signal erzeugt, und ein seiner Schwingungsfrequenz entsprechendes Schwingungssignal an einen zweiten digitalen Frequenzteiler (5) liefert, der daraus ein erstes Synchronisationssignal erzeugt, wobei der zweite Oszillator (2) ein seiner Schwingungsfrequenz entsprechendes Schwingungssignal an einen dritten digitalen Frequenzteiler (6) liefert, der daraus ein zweites Synchronisationssignal erzeugt und ein seiner Schwingungsfrequenz entsprechendes Schwingungssignal an einen vierten digitalen Frequenzteiler (7) liefert, der daraus ein drittes Synchronisationssignal erzeugt, wobei der dritte Oszillator (3) ein seiner Schwingungsfrequenz entsprechendes Schwingungssignal an einen fünften digitalen Frequenzteiler (8) liefert, der daraus ein viertes Synchronisationssignal erzeugt und ein seiner Schwingungsfrequenz entsprechendes Schwingungssignal an einen sechsten digitalen Frequenzteiler (9) liefert, der daraus das zweite Signal erzeugt, wobei das erste Synchronisationssignal und das zweite Synchronisationssignal einem ersten Phasenvergleicher (10) zugeführt werden, der in Abhängigkeit von der Phasendifferenz des ersten Synchronisationssignals zum zweiten Synchronisationssignal eine Spannung an einen ersten spannungsgesteuerten Oszillator (11) ausgibt, der die Schwingungsfrequenz des zweiten Oszillators (2) derart regelt, daß diese zur Schwingungsfrequenz des ersten Oszillators (1) in einem vorbestimmten festen Verhältnis steht, und wobei das dritte Synchronisationssignal und das vierte Synchronisationssignal einem zweiten Phasenvergleicher (12) zugeführt werden, der in Abhängigkeit von der Phasendifferenz des dritten Synchronisationssignals zum vierten Synchronisationssignal eine Spannung an einen zweiten spannungsgesteuerten Oszillator (13) ausgibt, der die Schwingungsfrequenz des dritten Oszillators (3) derart regelt, daß diese zur Schwingungsfrequenz des zweiten Oszillators (2) in einem vorbestimmten festen Verhältnis steht.

2. Anordnung nach Anspruch 1, dadurch gekennzeichnet, daß die Frequenz des ersten zeitlich alternierenden Signals und die Frequenz des zweiten zeitlich alternierenden Signals beide jeweils zwischen 0,1 und 10 MHz liegen, vorzugsweise etwa 1 MHz betragen.

3. Anordnung nach Anspruch 1 oder 2, dadurch gekennzeichnet, daß das vorbestimmte feste Frequenzverhältnis zwischen dem ersten zeitlich alternierenden Signal und dem zweiten zeitlich alternierenden Signal derart gewählt ist, daß der Differenzbetrag zwischen der Frequenz des ersten zeitlich alternierenden Signals und der Frequenz des zweiten zeitlich alternierenden Signals zwischen 1 und 10 Hz liegt, vorzugsweise etwa 4 Hz beträgt.

4. Anordnung nach einem der Ansprüche 1 bis 3, dadurch gekennzeichnet, daß die Schwingungsfrequenz des ersten Oszillators (1) 5 MHz beträgt, die Schwingungsfrequenz des zweiten Oszillators (2) 3,579545 MHz beträgt, die Schwingungsfrequenz des dritten Oszillators (3) etwa 4 MHz beträgt, die Frequenzteilung des ersten digitalen Frequenzteilers (4) 5 beträgt, die Frequenzteilung des zweiten digitalen Frequenzteilers (5) 264 beträgt, die Frequenzteilung des dritten digitalen Frequenzteilers (6) 189 beträgt, die Frequenzteilung des vierten digitalen Frequenzteilers (7) 647 beträgt, die Frequenzteilung des fünften digitalen Frequenzteilers (8) 723 beträgt und die Frequenzteilung des sechsten digitalen Frequenzteilers (9) 4 beträgt.

5. Anordnung nach einem der Ansprüche 1 bis 4, dadurch gekennzeichnet, daß der erste Oszillator (1), der zweite Oszillator (2) und der dritte Oszillator (3) jeweils einen Schwingquarz aufweisen.

6. Zeitbasisgenerator - vorzugsweise für ein TDR-Füllstandsmeßgerät - mit einer Anordnung nach einem der Ansprüche 1 bis 5.

7. TDR-Füllstandsmeßgerät mit einer Anordnung nach einem der Ansprüche 1 bis 6.

8. TDR-Füllstandsmeßgerät nach Anspruch 7, dadurch gekennzeichnet, daß die Meßdatenübertragung und die elektrische Versorgung des TDR-Füllstandsmeßgeräts ausschließlich über eine Zweidrahtleitung erfolgen.

9. Verfahren zum Erzeugen eines ersten zeitlich alternierenden Signals und eines zweiten zeitlich alternierenden Signals, das zum ersten Signal in einem vorbestimmten festen Frequenzverhältnis steht, wobei ein erstes Schwingungssignal mit einer ersten Schwingungsfrequenz, ein zweites Schwingungssignal mit einer zweiten Schwingungsfrequenz und ein drittes Schwingungssignal mit einer dritten Schwingungsfrequenz erzeugt werden, wobei das erste Signal aus dem ersten Schwingungssignal erzeugt wird, indem die Schwingungsfrequenz des erste Schwingungssignals um eine erste Frequenzteilung ganzzahlig heruntergeteilt wird, ein erstes Synchronisationssignal aus dem ersten Schwingungssignal erzeugt wird, indem die Schwingungsfrequenz des ersten Schwingungssignals um eine zweite Frequenzteilung ganzzahlig heruntergeteilt wird, ein zweites Synchronisationssignal aus dem zweiten Schwingungssignal erzeugt wird, indem die Schwingungsfrequenz des zweiten Schwingungssignals um eine dritte Frequenzteilung ganzzahlig heruntergeteilt wird, ein drittes Synchronisationssignal aus dem zweiten Schwingungssignal erzeugt wird, indem die Schwingungsfrequenz des zweiten Schwingungssignals um eine vierte Frequenzteilung ganzzahlig heruntergeteilt wird, ein viertes Synchronisationssignal aus dem dritten Schwingungssignal erzeugt wird, indem die Schwingungsfrequenz des dritten Schwingungssignals um eine fünfte Frequenzteilung ganzzahlig heruntergeteilt wird, und das zweite Signal aus dem dritten Schwingungssignal erzeugt wird, indem die Schwingungsfrequenz des dritten Schwingungssignals um eine sechste Frequenzteilung ganzzahlig heruntergeteilt wird, wobei die Phase des ersten Synchronisationssignals mit der Phase des zweiten Synchronisationssignals verglichen wird und die zweite Schwingungsfrequenz in Abhängigkeit von der Phasendifferenz des ersten Synchronisationssignals zum zweiten Synchronisationssignal derart geregelt wird, daß diese zur ersten Schwingungsfrequenz in einem vorbestimmten festen Verhältnis steht, und wobei die Phase des dritten Synchronisationssignals mit der Phase des vierten Synchronisationssignals verglichen wird und die dritte Schwingungsfrequenz in Abhängigkeit von der Phasendifferenz des dritten Synchronisationssignals zum vierten Synchronisationssignal derart geregelt wird, daß diese zur zweiten Schwingungsfrequenz in einem vorbestimmten festen Verhältnis steht.

10. Verfahren nach Anspruch 9, dadurch gekennzeichnet, daß die Frequenz des ersten zeitlich alternierenden Signals und die Frequenz des zweiten zeitlich alternierenden Signals beide jeweils zwischen 0,1 und 10 MHz liegen, vorzugsweise etwa 1 MHz betragen

11. Verfahren nach Anspruch 9 oder 10, dadurch gekennzeichnet, daß das vorbestimmte feste Frequenzverhältnis zwischen dem ersten zeitlich alternierenden Signal und dem zweiten zeitlich alternierenden Signal derart gewählt wird, daß der Differenzbetrag zwischen der Frequenz des ersten Signals und der Frequenz des zweiten Signals zwischen 1 und 10 Hz liegt, vorzugsweise etwa 4 Hz beträgt.

12. Verfahren nach einem der Ansprüche 9 bis 11, dadurch gekennzeichnet, daß die erste Schwingungsfrequenz 5 MHz beträgt, die zweite Schwingungsfrequenz 3,579545 MHz beträgt, die dritte Schwingungsfrequenz etwa 4 MHz beträgt, die erste Frequenzteilung 5 beträgt, die zweite Frequenzteilung 264 beträgt, die dritte Frequenzteilung 189 beträgt, die vierte Frequenzteilung 647 beträgt, die fünfte Frequenzteilung 723 beträgt und die sechste Frequenzteilung 4 beträgt.

13. Verfahren nach einem der Ansprüche 9 bis 12, dadurch gekennzeichnet, daß das erste Schwingungssignal, das zweite Schwingungssignal und das dritte Schwingungssignal jeweils mit einem Schwingquarz erzeugt werden.

14. Anwendung des Verfahrens nach einem der Ansprüche 9 bis 13 für einen Zeitbasisgenerator, vorzugsweise eines TDR-Füllstandsmeßgeräts, wobei die Meßdatenübertragung und die elektrische Versorgung ausschließlich über eine Zweidrahtleitung erfolgt.
